(19) Europäisches Patentamt

European Patent Office

Office européen des brevets

(11) **EP 4 521 078 A1**

(12) **EUROPEAN PATENT APPLICATION**

(43) Date of publication:
**12.03.2025 Bulletin 2025/11**

(21) Application number: **23196269.7**

(22) Date of filing: **08.09.2023**

(51) International Patent Classification (IPC):
**G01F 23/284** (2006.01)  **G01S 13/88** (2006.01)
**H01Q 1/22** (2006.01)  **G01F 25/20** (2022.01)

(52) Cooperative Patent Classification (CPC):
**G01F 23/284; G01F 25/20; G01R 29/0878;
G01S 13/88; H01Q 1/225**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Rosemount Tank Radar AB
435 23 Mölnlycke (SE)**

(72) Inventors:
• **GRAHN, Marcus
LINKÖPING (SE)**
• **DELIN, Håkan
LINKÖPING (SE)**
• **FRIEDMANN, Anders
LINKÖPING (SE)**
• **ERIKSSON, Mikael
VÄSTERVIK (SE)**

(74) Representative: **Kransell & Wennborg KB
P.O. Box 2096
403 12 Göteborg (SE)**

(54) **SYSTEM AND METHOD FOR ESTIMATING A SIGNAL PROPAGATION PROPERTY OF A SUBSTANCE COMPOSITION IN A PREDEFINED LEVEL RANGE**

(57)    A radar gauging system comprising a transceiver; a vertically extending transmission line probe coupled to the transceiver and configured to guide a transmit signal from the transceiver through the substance composition and to return a reflection signal resulting from reflection of the transmit signal, the transmission line probe having: a first probe portion configured to provide a first coupling between the transmit signal and the substance composition surrounding the first probe portion; and a second probe portion configured to provide a second coupling, weaker than the first coupling, between the transmit signal and the substance composition surrounding the second probe portion; and processing circuitry configured to estimate, based on a timing relation between the transmit signal and the reflection signal and on a known length of the first probe portion, a signal propagation property of the first level range of the substance composition surrounding the first probe portion.

*Fig. 1*

**EP 4 521 078 A1**

## Description

Technical Field of the Invention

The present invention relates to a radar gauging system for installation at a tank containing a substance composition, and to a method of estimating a signal propagation property of a substance composition.

Technical Background

In different industrial applications, there is a need to reliably separate different substances with different densities. As an illustrative example, the petroleum industry uses so-called phase separators for separating water, oil, and gas. The separated water, oil, and gas are output through different outlets for recycling, discharge or further refinement, for example. In this and other applications, it is desirable to achieve distinct separations, for example avoiding output of an emulsion of water and oil through either of the outlets intended for output of water or oil. There is thus a need for enabling an estimation of a material composition in a predefined level range in a tank, such as close to a bottom of the tank.

Summary of the Invention

In view of the above, it would be desirable to provide for improved estimation of a signal propagation property of a substance composition within a predefined level range. In particular, the predefined level range may be near a bottom of a tank.

According to a first aspect of the present invention, it is therefore provided a radar gauging system for installation at a tank containing a substance composition including at least a first substance having a first density, a second substance having a second density lower than the first density, and a third substance having a third density lower than the second density, the radar gauging system comprising: a transceiver for generating, transmitting and receiving electromagnetic signals; a vertically extending transmission line probe coupled to the transceiver and configured to guide an electromagnetic transmit signal from the transceiver at least partly through the substance composition and to return to the transceiver an electromagnetic reflection signal resulting from reflection of the transmit signal at one or more impedance discontinuities encountered thereby, the transmission line probe having: a first probe portion extending along the transmission line probe between a first probe position at a first distance from the transceiver and a second probe position at a second distance from the transceiver, shorter than the first distance, the first probe portion being configured to provide a first coupling between the transmit signal and the substance composition in a first level range surrounding the first probe portion; and a second probe portion extending along the transmission line probe between the second probe position and a third probe position at a third distance from the transceiver, shorter than the second distance, the second probe portion being configured to provide a second coupling between the transmit signal and the substance composition in a second level range surrounding the second probe portion, the second coupling being weaker than the first coupling provided by the first probe portion; and processing circuitry coupled to the transceiver and configured to estimate, based on a timing relation between the transmit signal and the reflection signal and on a known length of the first probe portion, a signal propagation property of the first level range of the substance composition surrounding the first probe portion.

The present invention is based upon the realization that a material composition within a predefined level range in a tank can be estimated using an estimation of a signal propagation property in that level range. The present inventors have further realized that such an estimation of a signal propagation property can be achieved using a transmission line probe that provides for sufficiently low signal loss between the transceiver and the predefined level range to allow the transmit signal to reach the first impedance discontinuity at the first probe position, and allow distinguishable reflected power from reflection of the transmit signal at the first impedance discontinuity to return to the transceiver, and also exhibits sufficient interaction with the surrounding medium within the predefined level range for the signal propagation property of the first level range of the substance composition to influence the propagation speed of the transmit signal (and reflection signal) along the transmission line probe within the predefined level range.

Hereby, estimation of a material composition in a predefined level range in a tank, such as close to a bottom of the tank, can be achieved without the need for a special tank feed-through or at least one additional measuring opening provided in the tank wall. Since a non-standard tank feed-through or at least one additional measuring opening may add cost and complexity, aspects of the present invention provide for simplified and more cost-efficient estimation of a material composition in a predefined level range in a tank, such as close to a bottom of the tank.

In various embodiments of the radar gauging system according to the present invention, the transmission line probe may comprise a probe conductor coupled to the transceiver; and a dielectric layer at least partly enclosing the probe conductor.

The dielectric layer may advantageously form a dielectric enclosing structure extending along a substantial portion of the transmission line probe, such as along the entire length of the transmission line probe arranged inside the tank.

This type of the transmission line probe can be referred to as a Partially External Dielectric (PED) transmission line probe.

The propagation velocity along a PED transmission line probe is characterized by an effective dielectric

constant $\varepsilon_{eff}$ which depends on the dielectric constant of the dielectric enclosing structure $\varepsilon_{int}$ and the dielectric constant of the surrounding medium $\varepsilon_{ext}$. The propagation velocity of the electromagnetic signal (transmit signal and reflection signal) travelling along the PED transmission line probe is given by the speed of light divided by the square root of $\varepsilon_{eff}$.

The effective dielectric constant $\varepsilon_{eff}$ of the PED transmission line probe at least approximately depends on the dielectric constant of the dielectric enclosing structure $\varepsilon_{int}$ and the dielectric constant of the surrounding medium $\varepsilon_{ext}$ according to the following relation:

$$\varepsilon_{eff} \sim \frac{1}{\dfrac{\alpha}{\epsilon_{ext}} + \dfrac{1-\alpha}{\varepsilon_{int}}}$$

where $\alpha$ is a number between 0 and 1 which indicates the degree of coupling to the surrounding medium. With $\alpha=1$, the probe conductor is uncoated (thus maximum influence of the surrounding medium), and with $\alpha=0$, the probe conductor is fully screened from the surrounding medium (the signal propagation is completely independent of the surrounding medium). It should be noted that, depending on the geometry of the transmission line probe, the exact calculation can be a bit different, but the important thing is that the coupling to the surrounding medium in the different probe portions can be adapted to fit the requirements by at least partly enclosing the probe conductor with different thicknesses of (the same) dielectric material in the different probe portions and/or by at least partly enclosing the probe conductor with different dielectric materials (having different relative dielectric constants) in the different probe portions.

For instance, the probe conductor can thus be at least partly surrounded by a relatively thin dielectric layer in the first probe portion, and by a relatively thick dielectric layer in the second probe portion.

In embodiments of the radar gauging system according to the present invention, the transmission line probe may advantageously comprise a a substantially uniform dielectric material coating with a thickness and material properties selected to achieve a first coupling coefficient $\alpha_1$ that is greater than 0.1 and less than 0.5 in the first probe portion, and a second coupling coefficient $\alpha_2$ that is greater than 0.6 in the second probe portion. As an illustrative and non-limiting example, the dielectric material coating may be made of PTFE and a have a thickness in the range 1 mm to 10 mm in the first probe portion and a thickness greater than 12 mm in the second probe portion.

Alternatively, or in combination, the transmission line probe may comprise: a probe conductor coupled to the transceiver; and a shielding conductor spaced apart from the probe conductor and extending along at least a portion of the transmission line probe. In particular, the shielding conductor may extend along the second probe portion to provide for the desired relatively weak coupling between the transmit signal and the substance composition in the second level range surrounding the second probe portion.

The shielding conductor may be connected to electrical ground, for instance through direct conductive connection to a conductive tank ceiling where applicable. Alternatively, the shielding conductor may be electrically floating.

In embodiments of the radar gauging system according to the present invention, the transmission line probe may comprise a third probe portion extending along the transmission line probe between the third probe position and a fourth probe position at a fourth distance from the transceiver, shorter than the third distance, the third probe portion being configured to provide a third coupling between the transmit signal and the substance composition in a third level range surrounding the third probe portion, the third coupling being stronger than the second coupling provided by the second probe portion.

For instance, the transmission line probe may comprise a probe conductor and a dielectric layer at least partly enclosing the probe conductor, and the thickness of the dielectric layer may be the same or thinner in the third probe portion as in the first probe portion. In one example configuration, the probe conductor may be uncoated in the third probe portion.

In embodiments where the transmission line probe has the above-described third probe portion, the processing circuitry may be configured to determine a level in the tank of an interface between the second substance and the third substance based on a timing relation between the transmit signal and the reflection signal indicating a reflection in the third level range.

Advantageously, the radar gauging system according to various embodiments of the present invention may be included in a phase separator arrangement, additionally comprising a tank elongated in a substantially horizontal first direction, and extending in the first direction between a first tank end and a second tank end; an inlet adjacent to the first tank end for receiving a flow of a substance composition including at least a liquid first substance having a first density and a liquid second substance having a second density lower than the first density; an overflow weir arranged at a weir position between the inlet and the second tank end; a first outlet arranged at a bottom of the tank horizontally between the inlet and the weir position, for output of first substance separated from the substance composition; and a second outlet arranged at a bottom of the tank horizontally between the weir position and the second tank end, for output of second substance separated from the substance composition. The radar gauging system may be arranged to gauge the substance composition at a gauging position between the inlet and the weir position.

Using information obtainable from the radar gauging system, operation of this phase separator arrangement can be optimized. For instance, a flow rate of the substance composition provided to the inlet can be controlled based on the estimation of the signal propagation property of the first level range of the substance composition provided by the radar gauging system. In particular, the estimation of the signal propagation property may indicate the efficiency of the separation of the substance composition into the first substance and the second substance. If the estimation of the signal propagation property indicates a separation that is below a predefined threshold separation, the flow rate of the substance composition through the inlet may be reduced or the flow of substance composition through the inlet may be temporarily stopped, and/or the flow through one or more of the outlets may be temporarily stopped.

According to a second aspect of the present invention, it is provided a method of estimating a signal propagation property of a substance composition in a predefined first level range, the method comprising: generating and transmitting, by a transceiver, an electromagnetic transmit signal; providing the transmit signal to an upper probe end of a vertically extending transmission line probe having a first probe portion surrounded by the substance composition in the first level range and configured to provide a first coupling between the transmit signal and the substance composition in the first level range, and a second probe portion between the transceiver and the first probe portion and configured to provide a second coupling between the transmit signal and the substance composition in a second level range surrounding the second probe portion, the second coupling being weaker than the first coupling provided by the first probe portion; receiving, by the transceiver from the transmission line probe, an electromagnetic reflection signal resulting from reflection of the transmit signal at one or more impedance discontinuities encountered thereby; and estimating, by processing circuitry coupled to the transceiver, the signal propagation property of the first level range of the substance composition surrounding the first probe portion, based on a timing relation between the transmit signal and the reflection signal and on a known length of the first probe portion.

According to various embodiments, the method may comprise determining, by the processing circuitry, a measure indicative of a proportion of the first substance in first level range based on the estimated signal propagation property of the first level range, a known signal propagation property of the first substance, and a known signal propagation property of the second substance.

Further embodiments of, and effects obtained through this second aspect of the present invention are largely analogous to those described above for the first aspect of the invention.

In summary, the present invention thus relates to a radar gauging system comprising a transceiver; a vertically extending transmission line probe coupled to the transceiver and configured to guide a transmit signal from the transceiver through the substance composition and to return a reflection signal resulting from reflection of the transmit signal, the transmission line probe having: a first probe portion configured to provide a first coupling between the transmit signal and the substance composition surrounding the first probe portion; and a second probe portion configured to provide a second coupling, weaker than the first coupling, between the transmit signal and the substance composition surrounding the second probe portion; and processing circuitry configured to estimate, based on a timing relation between the transmit signal and the reflection signal and on a known length of the first probe portion, a signal propagation property of the substance composition in the first level range of the substance composition surrounding the first probe portion.

Brief Description of the Drawings

These and other aspects of the present invention will now be described in more detail, with reference to the appended drawings showing example embodiments of the invention, wherein:

Fig 1 schematically illustrates a phase separator arrangement comprising a radar gauging system according to an embodiment of the present invention;
Fig 2 is a schematical functional illustration of a radar gauging system according to the present invention;
Fig 3A is a schematic illustration of an example of a transmission line probe that may be comprised in the radar gauging system according to examples of the present invention;
Fig 3B is a schematic diagram illustrating the signal coupling to the surrounding medium provided by the transmission line probe in fig 3A as a function of position along the probe;
Figs 4A-B schematically illustrate a first example configuration of the transmission line probe in fig 3A;
Figs 5A-B schematically illustrate a second example configuration of the transmission line probe in fig 3A;
Fig 6A is a schematic illustration of an example of a transmission line probe that may be comprised in the radar gauging system according to examples of the present invention;
Fig 6B is a schematic diagram illustrating the signal coupling to the surrounding medium provided by the transmission line probe in fig 6A as a function of position along the probe;
Fig 7 is a flow-chart schematically illustrating an example of the method according to the present invention;
Fig 8 is an exemplary echo curve obtained using the transmission line probe in fig 3A; and
Fig 9 is an exemplary echo curve obtained using the transmission line probe in fig 6A.

Detailed Description of an Example Embodiment of the Invention

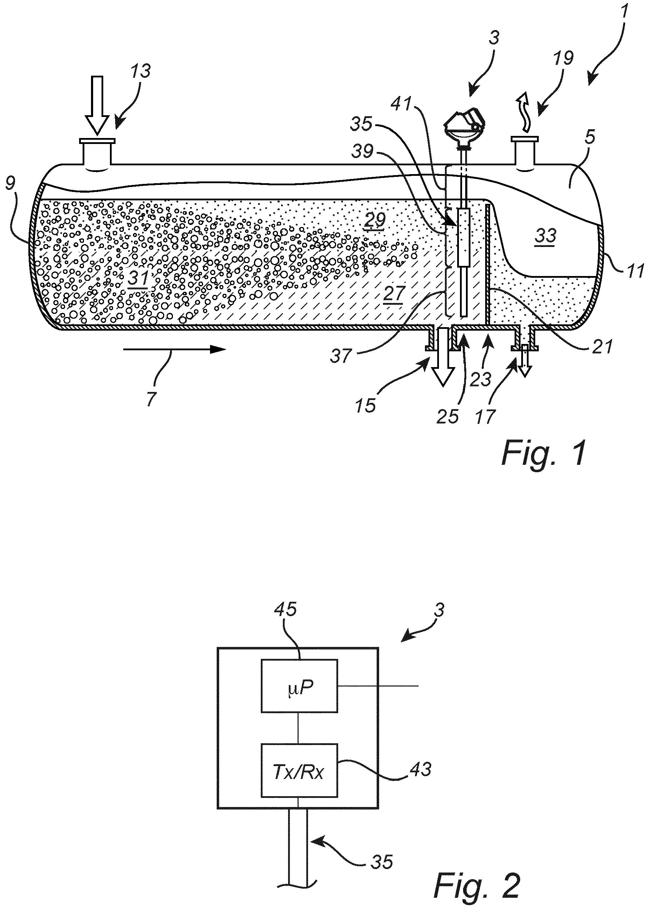

Fig 1 schematically illustrates a phase separator arrangement 1 comprising a radar gauging system 3 according to an embodiment of the present invention. The phase separator arrangement 1 additionally comprises a tank 5 that is elongated in a substantially horizontal first direction 7, and extends in the first direction 7 between a first tank end 9 and a second tank end 11. As can be seen in fig 1, the tank 5 has an inlet 13, a first outlet 15, a second outlet 17, an optional third outlet 19, and an overflow weir 21.

The inlet 13 is arranged adjacent to the first tank end 9, the overflow weir 21 is arranged at a weir position 23, spaced apart from the inlet 13 in the first direction 7, the first outlet 15 is arranged at a bottom of the tank 5 horizontally between the inlet 13 and the weir position 23, the second outlet 17 is arranged at the bottom of the tank 5 horizontally between the weir position 23 and the second tank end 11, the optional third outlet 19 is arranged at the top of the tank 5, and the radar gauging system 3 is arranged at a gauging position 25, horizontally between the inlet 13 and the weir position 23.

When the phase separator arrangement 1 is in use, a flow of a substance composition is received through the inlet 13. The substance composition includes at least a liquid first substance 27 having a first density, and a liquid second substance 29 having a second density, lower than the first density. The first substance 27 may, for example, be water, and the second substance 29 may, for example, be oil. When entering the tank 5 through the inlet, the substance composition may be in the form of an emulsion 31 of the first substance 27 and the second substance 29. When progressing through the tank in the horizontal first direction 7 at an appropriate rate, the emulsion 31 is separated into pure first substance 27 at the bottom of the tank 5, with pure second substance 29 floating on top of the first substance 27. Beetween the thus separated layers of first substance 27 and second substance 29, an emulsion boundary layer may remain. First substance 27 is output through the first outlet 15, and second substance 29 is output through the second outlet 17, after having flowed over the overflow weir 21. A third, gaseous substance 33, may be output through the third outlet 19.

As is schematically indicated in fig 1, the exemplary radar gauging system 3 comprises a vertically extending transmission line probe 35, having a first probe portion 37, a second probe portion 39, and an optional third probe portion 41. In this example configuration, the first probe portion 37 can be used for estimating a signal propagation property, such as dielectric constant, of the substance composition in a first level range surrounding the first probe portion 37, and the third probe portion 41 can be used for determining the level of the second substance 29, such as oil, in the tank 5. One or both of these measures may be used for controlling operation of the phase separator arrangement 1, for instance by controlling the flow rate of substance composition at the inlet 13. If the estimated signal propagation property in the first level range surrounding the first probe portion 37 indicates that there is a mixture of first substance 27 and second substance 29 at the bottom of the tank 5 at the first outlet 15, the first oulet 15 may be closed and the flow of substance composition at the inlet stopped 13 to ensure that second substance 29, such as oil, is not discarded to the environment through the first outlet 15. Through the use of the radar gauging system 3 according to embodiments of the present invention, improved operation of the phase separation arrangement 1 can thus be provided for, without the need for additional openings in the tank 5.

Fig 2 is a schematical functional illustration of a radar gauging system 3 according to the present invention. Referring to fig 2, the radar gauging system 3 comprises the above-mentioned transmission line probe 35, a transceiver 43, and processing circuitry 45. The transceiver 43 is coupled to the transmission line probe 35, and is configured to generate and transmit an electromagnetic transmit signal $S_T$ to the transmission line probe 35. The transmit signal $S_T$ is then guided by the transmission line probe 35, and an electromagnetic transmit signal $S_R$ resulting from reflection of the transmit signal $S_T$ at one or more impedance discontinuities encountered by the transmit signal $S_T$ is guided by the transmission line probe 35 back towards the transceiver 43. The transceiver 43 is configured to receive the reflection signal $S_R$. By evaluating a timing relation between the transmit signal $S_T$ and the reflection signal $S_R$, using techniques that are *per* se well-known to the person of ordinary skill in the art, the processing circuitry 45 may be configured to estimate the distance from a reference location at an interface between the transceiver 43 and the transmission line probe 35 and the one or more impedance discontinuities, and/or the distance between impedance discontinuities. By comparing a distance thus estimated based on a time-of-flight of the transmit signal $S_T$ (and reflection signal $S_R$) along the transmission line probe 35 with the corresponding known distance, the propagation speed of the transmit signal $S_T$ (and reflection signal $S_R$) can be estimated. From the estimated propagation speed another signal propagation property, such as the (average) dielectric constant, can be estimated, and/or conclusions can be drawn about the material composition through which the transmit signal $S_T$ (and reflection signal $S_R$) has been propagated.

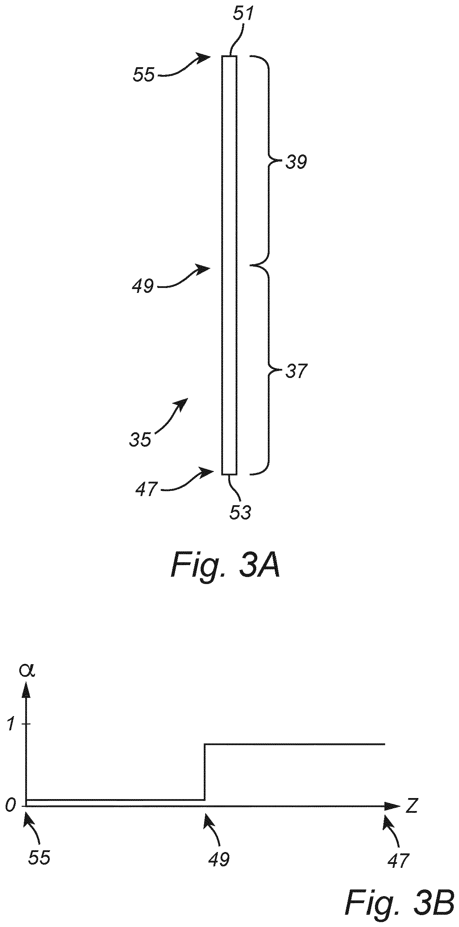

Fig 3A is a schematic illustration of an example of a transmission line probe 35 that may be comprised in the radar gauging system 3 according to examples of the present invention. The transmission line probe 35 in fig 3A has a first probe portion 37 and a second probe portion 39. The first probe portion 37 extends along the transmission line probe 35 between a first probe position 47 and a second probe position 49, which is closer to the upper probe end 51 than the first probe position 47 is. The first probe position 37 is defined by an impedance discontinuity, which may, for example, be provided by the lower probe end 53, or a reference impedance discontinuity spaced apart from the lower probe end 53. The second probe portion 39 extends along the transmission line probe 35 between the second probe position 49 and a third probe position 55, which is closer to the upper probe end 51 than the second probe position 49 is.

The first probe portion 37 is configured to provide a first coupling between the transmit signal $S_T$ guided by the transmission line probe 35 through a substance composition and the substance composition in a first level range surrounding the first probe portion 37, and the second probe portion 39 is configured to provide a second coupling between the transmit signal $S_T$ guided by the transmission line probe 35 through a substance composition and the substance composition in a second level range surrounding the first probe portion 39. The second coupling provided by the second probe portion 39 is weaker than the first coupling provided by the first probe portion 37.

An exemplary signal coupling to the surrounding medium provided by the transmission line probe 35 in fig 3A as a function of position z (distance from the upper probe end 51) along the probe 35 is schematically shown in fig 3B.

In fig 3B, the signal coupling to the surrounding medium is represented by the a coupling coefficient $\alpha$ that can be a number between 0 and 1. The value 0 indicates that there is no coupling between the transmit signal $S_T$ and the substance composition surrounding the transmission line probe 35, and the value 1 indicates that there is maximum coupling. Maximum coupling for a given transmission line probe 35 is obtained with one or more probe conductors being uncoated and unshielded, allowing maximum interaction with the surrounding material composition.

When there is no coupling between the transmit signal $S_T$ and the substance composition surrounding (the portion of) the transmission line probe 35, there will be no signal attenuation due to interaction of the transmit signal with the substance composition, and the signal propagation properties (such as dielectric constant) of the substance composition will not affect the propagation speed of the transmit signal $S_T$ (or reflection signal) guided by (the portion of) the transmission line probe 35.

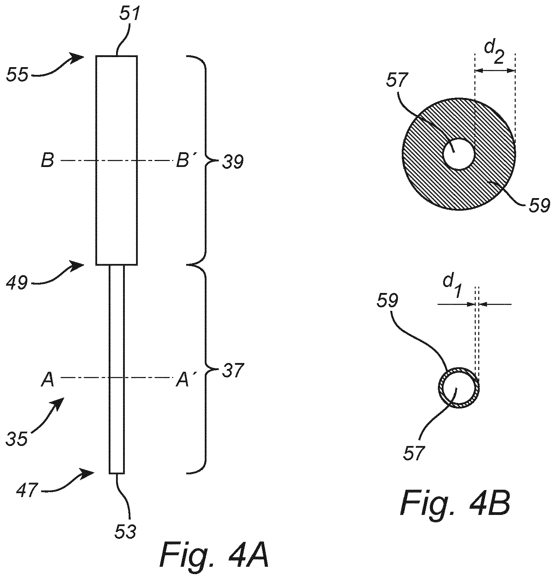

Figs 4A-B schematically illustrate a first example configuration of the transmission line probe 35 in fig 3A. Fig 4A is a schematic (proportions are not to scale) side view of the configuration of the transmission line probe 35, and fig 4B schematically shows cross-sections of the transmission line probe 35 in fig 4A, of sections taken along the lines A-A' and B-B', respectively.

In the first example configuration shown in figs 4A-B, the transmission line probe 35 comprises a probe conductor 57 coupled to the transceiver 43 (not shown in figs 4A-B), and a dielectric layer 59 enclosing the probe conductor 57. In the example configuration of figs 4A-B, the dielectric layer 59 is configured to provide the first coupling between the transmit signal $S_T$ and the substance composition in the first level range surrounding the first probe portion 37, and to provide the second coupling between the transmit signal $S_T$ and the substance composition in the second level range surrounding the second probe portion 39. In this example configuration, the dielectric layer 59 has a first thickness $d_1$ in the first probe portion 37, and a second thickness $d_2$, greater than the first thickness $d_1$, in the second probe portion 39. In this example configuration, the dielectric material 59 may be the same, for example PTFE, in the first probe portion 37 and in the second probe portion 39. In an alternative configuration, there may be different dielectric materials with different dielectric constant in the first probe portion 37 and the second probe portion 39. In that case, using a dielectric material in the first probe portion 37 with a higher dielectric constant than the dielectric material in the second probe portion 39, the difference in dielectric material thickness between the probe portions may be smaller, or the dielectric material thickness may even be the same in the first 37 and second 39 probe portions.

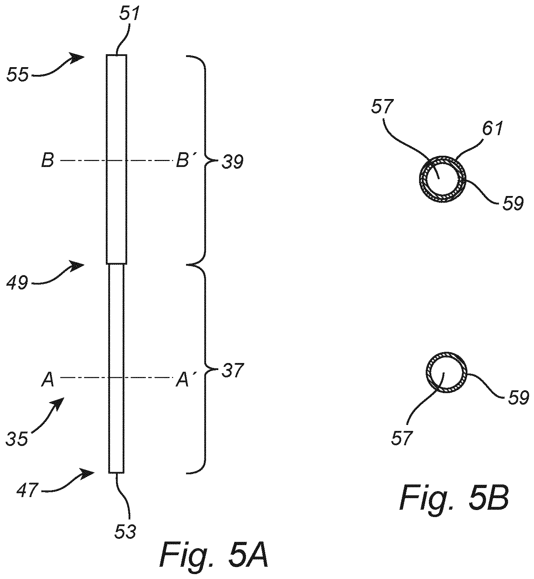

Figs 5A-B schematically illustrate a second example configuration of the transmission line probe 35 in fig 3A. Fig 5A is a schematic (proportions are not to scale) side view of the configuration of the transmission line probe 35, and fig 5B schematically shows cross-sections of the transmission line probe 35 in fig 5A, of sections taken along the lines A-A' and B-B', respectively.

In the second example configuration shown in figs 5A-B, the transmission line probe 35 comprises a probe conductor 57 coupled to the transceiver 43 (not shown in figs 5A-B), and a dielectric layer 59 enclosing the probe conductor 57. In the example configuration of figs 5A-B, the transmission line probe 35 further comprises a shielding conductor 61 spaced apart from the probe conductor 57, by the dielectric layer 59, and extending along the second probe portion 39. Through the use of the shielding conductor 61 in figs 5A-B, the second coupling between the transmit signal $S_T$ and the substance composition in the second level range surrounding the second probe portion 39 can be substantially eliminated, so that the signal propagation along the second probe portion 39 is substantially independent of the propagation properties of the surrounding substance composition, in the second level range.

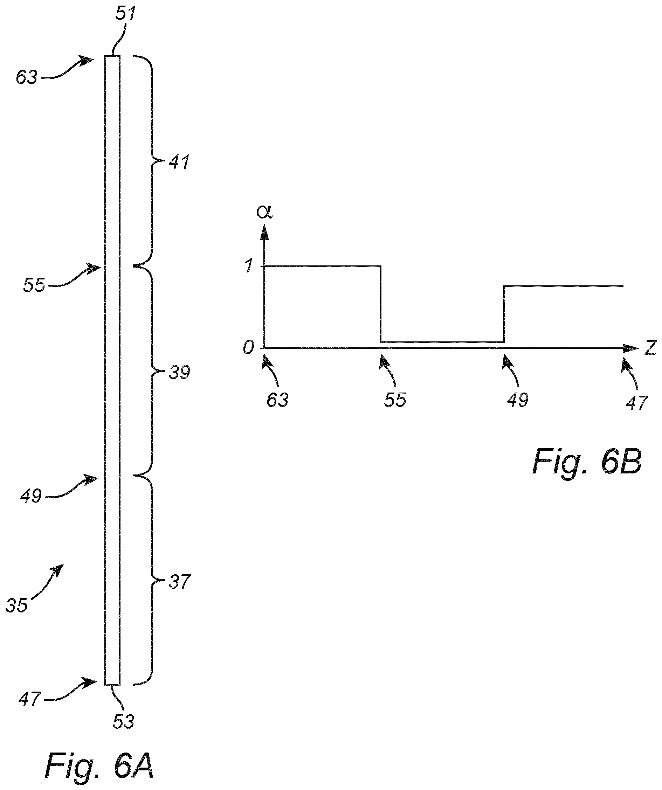

Fig 6A is a schematic illustration of an example of a transmission line probe 35 that may be comprised in the radar gauging system 3 according to examples of the present invention. The transmission line probe 35 in fig 6A has a first probe portion 37, a second probe portion 39, and a third probe portion 41. The third probe portion 41 extends along the transmission line probe 35 between the third probe position 55 and a fourth probe position 63, which is closer to the upper probe end 51 than the third probe position 55 is.

The third probe portion 41 is configured to provide a third coupling between the transmit signal $S_T$ guided by the transmission line probe 35 through a substance composition and the substance composition in a third level range surrounding the third probe portion 41. The third coupling provided by the third probe portion 41 is stronger than the second coupling provided by the second probe portion 39, and may advantageously also be stronger than the first coupling provided by the first probe portion 37.

An exemplary signal coupling to the surrounding medium provided by the transmission line probe 35 in fig 6A as a function of position z (distance from the upper probe end 51) along the probe 35 is schematically shown in fig 6B. The different couplings for the different probe portions in this probe configuration can be achieved in, for example, the same ways as described above with reference to figs 4A-B and figs 5A-B.

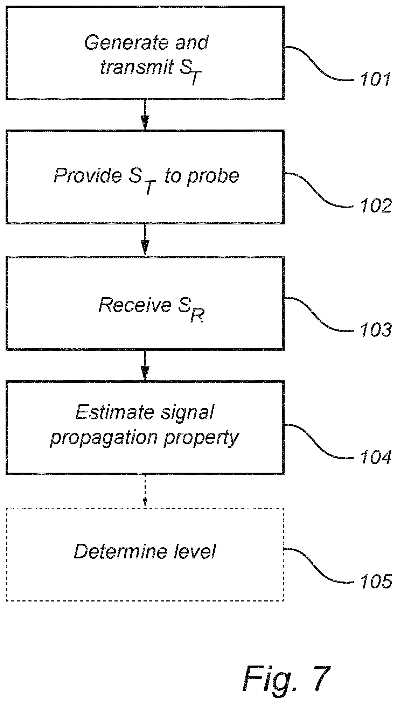

A method according to an example of the present invention will now be described with reference to the flow-chart in fig 7. Other figures may also be referred to as indicated in the text.

Referring to fig 7, an electromagnetic transmit signal $S_T$ is generated and transmitted 101, by a transceiver 43. The transmit signal $S_T$ may, for example, be provided in the form of a pulse train and/or as a continuous signal with time-varying frequency, as will be *per se* well-known to one of ordinary skill in the art.

The transmit signal $S_T$ is provided 102 to an upper probe end 51 of a vertically extending transmission line probe 35 having a first probe portion 37 surrounded by a substance composition in the first level range and configured to provide a first coupling between the transmit signal $S_T$ and the substance composition in the first level range, and a second probe portion 39 between the transceiver 43 and the first probe portion 37 and configured to provide a second coupling between the transmit signal $S_T$ and the substance composition in a second level range surrounding the second probe portion 39, the second coupling being weaker than the first coupling provided by the first probe portion 37.

An electromagnetic reflection signal $S_R$ resulting from reflection of the transmit signal at one or more impedance discontinuities encountered thereby is received 103 by the transceiver 43 from the transmission line probe 35.

Thereafter, a signal propagation property, such as the (average) dielectric constant, of the first level range of the substance composition surrounding the first probe portion 37 is estimated 104 by the processing circuitry 45, based on a timing relation between the transmit signal $S_T$ and the reflection signal $S_R$ and on a known length of the first probe portion 37.

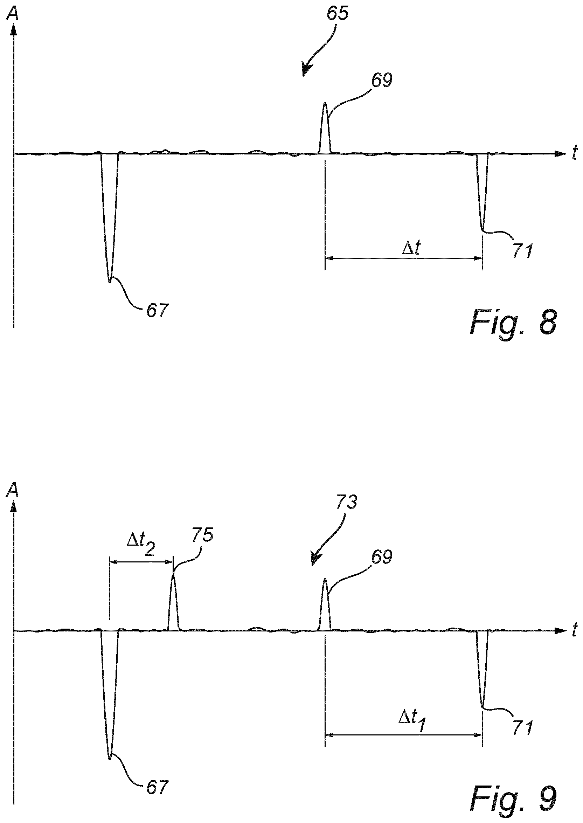

Fig 8 is an exemplary echo curve 65 obtained using the transmission line probe 35 in fig 3A. The echo curve, which illustrates a relation between time-of-flight t for each echo and the amplitude A of the echo signal, may, for example, be obtained using time-expansion techniques that are *per se* well-known in the field of level gauging using pulsed electromagnetic signals. As can be seen in the schematic echo curve 65 in fig 8, there is a first echo peak 67, a second echo peak 69, and a third echo peak 71. The first echo peak 67 results from reflection of the transmit signal $S_T$ at the impedance discontinuity provided by the connection between the transceiver 43 and the upper probe end 51. This echo peak 67 is used as a reference position indicating the top of the tank 5, and is sometimes referred to as a fiducial pulse. In the exemplary echo curve 65 in fig 8, the second echo peak 69 results from reflection of the transmit signal $S_T$ at an optional impedance discontinuity at the second probe position 49 indicating the interface between the first probe portion 37 and the second probe portion 39. The third echo peak 71 results from reflection of the transmit signal $S_T$ at the impedance discontinuity defining the first probe position 47. As was mentioned further above, this impedance discontinuity may, for example, be provided by the lower end of the transmission line probe 35. It should be noted that there are no significant echo peaks between the first echo peak 67 and the second echo peak, although the transmit signal $S_T$, in the example application in fig 1 using the probe configuration in fig 3A, may be guided by the second probe portion 39 of the transmission line probe 35 past two substance interfaces (from the third substance 33 to the second substance 29, and from the second substance 29 to the first substance 27). Due to the (very) weak coupling (low $\alpha$) in this example, the transmit signal $S_T$ does not see any significant change in impedance of the transmission line probe 35 when passing these substance interfaces. Therefore, very little signal strength is lost along the second probe portion 39, providing for relatively strong and easy to detect echo peaks.

Thus, an "electrical distance" between the first probe position 47 and the second probe position 49 can be determined based on the difference in time-of-flight $\Delta t$ for the second echo peak 69 and the third echo peak, respectively. The thus determined electrical distance is a function of the difference in time-of-flight $\Delta t$ and the propagation speed of the transmit signal of the first level range of the substance composition surrounding the first probe portion 37. Accordingly, the propagation speed can be estimated based on the electrical distance (or the difference in time-of-flight) and the known length of the first probe portion 37 (the physical distance between the first probe position 47 and the second probe position 49). From the propagation speed, a signal propagation property (such as the average relative dielectric constant) of the first level range can be estimated. From the signal propagation property, in turn, conclusions can be drawn about the substance composition in the first level range. For instance, as in the case of the phase separator arrangement 1 in fig 1, it can be determined if the first probe portion 37 is surrounded by pure water, or by an oil-water emulsion and, if so, the emulsion ratio. In applications where the first substance is water or another substance with a very high dielectric constant, it may be beneficial to provide the first probe portion with a thin coating of a dielectric material, such as PTFE.

As an alternative to estimating the signal propagation property of the first level range based on the electrical distance between the first probe position 47 and the second probe position 49, the electrical distance from the first echo peak 67 (the reference echo peak) to the echo peak 71 resulting from reflection of the transmit signal $S_T$ at the impedance discontinuity defining the first probe position 47 can be used analogously. This is possible when the second coupling provided by the second probe portion 39 is so weak that the influence of the surrounding medium on the propagation speed of the transmit signal $S_T$ is negligible along the second probe portion 39.

Optionally, and depending on the configuration of the transmission line probe 35, the level in the tank 5 of the interface between the second substance 29 (such as oil) and the third substance 33 (such as the gaseous tank atmosphere) may be determined 105 based on a timing relation between the transmit signal $S_T$ and the reflection signal $S_R$ indicating a reflection in the third level range surrounding the third probe portion 41 of the transmission line probe configuration in fig 6A.

Fig 9 is an exemplary echo curve 73 obtained using the transmission line probe 35 in fig 6A. In addition to the echo peaks of the echo curve 65 in fig 8, the echo curve 73 obtained using this probe configuration, for the same measurement situation, contains an additional fourth echo peak 75 resulting from reflection of the transmit signal $S_T$ at the impedance discontinuity provided by the interface between the second substance 29 (such as oil) and the third substance 33 (such as the gaseous tank atmosphere). Using this probe configuration, the signal propagation property in the first level range can thus be determined using a single transmission line probe 35 based on the difference in time-of-flight $\Delta t_1$ indicated by the second echo peak 69 and the third echo peak 71, and the level of the second substance 29 in the tank 5 can be determined based on the difference in time-of-flight $\Delta t_2$ indicated by the first echo peak 67 and the fourth echo peak 75.

The person skilled in the art realizes that the present invention by no means is limited to the preferred embodiments described above. For example, other probe arrangements may be feasible.

The "substances" are not, in general, limited to any particular material phase, and may thus include solids, liquids and gases. Some examples of substances can be various petroleum products, water, sludge or sand etc.

The "transceiver" may be one functional unit capable of transmitting and receiving electromagnetic signals, or may be a system comprising separate transmitter and receiver units.

The tank may be any container or vessel capable of containing a product, and may be metallic, or partly or completely non-metallic, open, semi-open, or closed.

## Claims

1. A radar gauging system for installation at a tank containing a substance composition including at least a first substance having a first density, a second substance having a second density lower than the first density, and a third substance having a third density lower than the second density, the radar gauging system comprising:

   a transceiver for generating, transmitting and receiving electromagnetic signals;
   a vertically extending transmission line probe coupled to the transceiver and configured to guide an electromagnetic transmit signal from the transceiver at least partly through the substance composition and to return to the transceiver an electromagnetic reflection signal resulting from reflection of the transmit signal at one or more impedance discontinuities encountered thereby, the transmission line probe having:

      a first probe portion extending along the transmission line probe between a first probe position defined by an impedance discontinuity at a first distance from the transceiver and a second probe position at a second distance from the transceiver, shorter than the first distance, the first probe portion being configured to provide a first coupling between the transmit signal and the substance composition in a first level range surrounding the first probe portion; and
      a second probe portion extending along the transmission line probe between the second probe position and a third probe position at a third distance from the transceiver, shorter than the second distance, the second probe portion being configured to provide a second coupling between the transmit signal and the substance composition in a second level range surrounding the second probe portion, the second coupling being weaker than the first coupling provided by the first probe portion; and

   processing circuitry coupled to the transceiver and configured to estimate, based on a timing relation between the transmit signal and the reflection signal and on a known length of the first probe portion, a signal propagation property of the first level range of the substance composition surrounding the first probe portion.

2. The radar gauging system according to claim 1, the processing circuitry being configured to determine, based on the estimated signal propagation property of the first level range, a known signal propagation property of the first substance, and a known signal propagation property of the second substance, a measure indicative of a proportion of the first substance in the first level range.

3. The radar gauge system according to claim 1 or 2, the transmission line probe extending between an upper probe end coupled to the transceiver and a lower probe end, the first probe position being at the lower probe end.

4. The radar gauging system according to any one of the preceding claims, the second probe portion being configured in such a way that the second coupling is sufficiently weak that a propagation speed of the transmit signal along the second probe portion is substantially independent of a signal propagation property of a second level range of the substance composition surrounding the second probe portion.

5. The radar gauging system according to any one of the preceding claims, the transmission line probe comprising:

   a probe conductor coupled to the transceiver; and
   a dielectric layer at least partly enclosing the probe conductor.

6. The radar gauging system according to claim 5, the dielectric layer fully enclosing the probe conductor in the first probe portion and in the second probe portion.

7. The radar gauging system according to claim 5 or 6, the dielectric layer being configured to provide the first coupling between the transmit signal and the substance composition in the first level range surrounding the first probe portion, and to provide the second coupling between the transmit signal and the substance composition in the second level range surrounding the second probe portion.

8. The radar gauging system according to claim 7, the dielectric layer being thicker in the second probe portion than in the first probe portion.

9. The radar gauging system according to any one of claims 1 to 4, the transmission line probe comprising:

   a probe conductor coupled to the transceiver; and
   a shielding conductor spaced apart from the probe conductor and extending along at least a portion of the transmission line probe.

10. The radar gauging system according to any one of the preceding claims, the transmission line probe comprising a third probe portion extending along the transmission line probe between the third probe position and a fourth probe position at a fourth distance from the transceiver, shorter than the third distance, the third probe portion being configured to provide a third coupling between the transmit signal and the substance composition in a third level range surrounding the third probe portion, the third coupling being stronger than the second coupling provided by the second probe portion.

11. The radar gauging system according to claim 10, the processing circuitry being configured to:
    determine a level in the tank of an interface between the second substance and the third substance based on a timing relation between the transmit signal and the reflection signal indicating a reflection in the third level range.

12. A phase separator arrangement, comprising:

    a tank elongated in a substantially horizontal first direction, and extending in the first direction between a first tank end and a second tank end;
    an inlet adjacent to the first tank end for receiving a flow of a substance composition including at least a liquid first substance having a first density and a liquid second substance having a second density lower than the first density;
    an overflow weir arranged at a weir position between the inlet and the second tank end;
    a first outlet arranged at a bottom of the tank horizontally between the inlet and the weir position, for output of first substance separated from the substance composition;
    a second outlet arranged at a bottom of the tank horizontally between the weir position and the second tank end, for output of second substance separated from the substance composition; and
    the radar gauging system according to any one of claims 1 to 11 arranged to gauge the substance composition at a gauging position between the inlet and the weir position.

13. The phase separator arrangement according to claim 12, wherein the radar gauging system is arranged horizontally between the first outlet and the weir position.

14. A method of estimating a signal propagation property of a substance composition in a predefined first level range, the method comprising:

generating and transmitting, by a transceiver, an electromagnetic transmit signal;

providing the transmit signal to an upper probe end of a vertically extending transmission line probe having a first probe portion surrounded by the substance composition in the first level range and configured to provide a first coupling between the transmit signal and the substance composition in the first level range, and a second probe portion between the transceiver and the first probe portion and configured to provide a second coupling between the transmit signal and the substance composition in a second level range surrounding the second probe portion, the second coupling being weaker than the first coupling provided by the first probe portion;

receiving, by the transceiver from the transmission line probe, an electromagnetic reflection signal resulting from reflection of the transmit signal at one or more impedance discontinuities encountered thereby; and

estimating, by processing circuitry coupled to the transceiver, the signal propagation property of the first level range of the substance composition surrounding the first probe portion, based on a timing relation between the transmit signal and the reflection signal and on a known length of the first probe portion.

15. The method according to claim 14, comprising: determining, by the processing circuitry, a measure indicative of a proportion of the first substance in first level range based on the estimated signal propagation property of the first level range, a known signal propagation property of the first substance, and a known signal propagation property of the second substance.

Fig. 1

Fig. 2

*Fig. 3A*

*Fig. 3B*

*Fig. 4A*

*Fig. 4B*

Fig. 5A

Fig. 5B

Fig. 6A

Fig. 6B

Generate and
transmit $S_T$ — 101

Provide $S_T$ to probe — 102

Receive $S_R$ — 103

Estimate signal
propagation property — 104

Determine level — 105

Fig. 7

Fig. 8

Fig. 9

Europäisches
Patentamt

European
Patent Office

Office européen
des brevets

# EUROPEAN SEARCH REPORT

Application Number

**EP 23 19 6269**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2019/063982 A1 (KESBA MAHMOUD KHODJET [FR]) 28 February 2019 (2019-02-28) * paragraphs [0010], [0059] – [0070]; figure 1 * | 1-15 | INV. G01F23/284 G01S13/88 H01Q1/22 G01F25/20 |
| Y | US 2018/094962 A1 (EDVARDSSON OLOV [SE] ET AL) 5 April 2018 (2018-04-05) * paragraphs [0068] – [0080]; figure 2A * | 1-15 | |
| Y | US 2020/072652 A1 (OURA HIDETO [JP] ET AL) 5 March 2020 (2020-03-05) | 2,15 | |
| A | * paragraphs [0036] – [0039] * | 1,3-14 | |
| Y | US 2018/094963 A1 (ERIKSSON MIKAEL [SE]) 5 April 2018 (2018-04-05) | 7,8 | |
| A | * paragraphs [0058] – [0060]; figure 3 * | 1-6, 9-11,14, 15 | |
| Y | US 2022/260470 A1 (JANITCH PAUL G [US] ET AL) 18 August 2022 (2022-08-18) | 12,13 | |
| A | * paragraphs [0015], [0036] – [0039]; figure 1 * | 1-11,14, 15 | |
| A | US 2007/194799 A1 (CAROBBIO VITTORINO [IT]) 23 August 2007 (2007-08-23) * paragraphs [0062] – [0068]; figure 2 * | 1-15 | |
| A | US 2009/302867 A1 (SCHROTH HERBERT [DE] ET AL) 10 December 2009 (2009-12-10) * paragraphs [0044] – [0054]; figure 1 * | 1-15 | |
| A | US 2014/104099 A1 (JANITCH PAUL G [US]) 17 April 2014 (2014-04-17) * paragraphs [0040], [0041]; figure 7 * | 1-15 | |

TECHNICAL FIELDS
SEARCHED (IPC)

G01F
G01R
H01Q
G01S

The present search report has been drawn up for all claims

| Place of search | Date of completion of the search | Examiner |
|---|---|---|
| The Hague | 5 February 2024 | Tomasoni, Flora |

EPO FORM 1503 03.82 (P04C01)

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.........................................................................
& : member of the same patent family, corresponding document

## ANNEX TO THE EUROPEAN SEARCH REPORT
## ON EUROPEAN PATENT APPLICATION NO.

EP 23 19 6269

This annex lists the patent family members relating to the patent documents cited in the above-mentioned European search report.
The members are as contained in the European Patent Office EDP file on
The European Patent Office is in no way liable for these particulars which are merely given for the purpose of information.

05-02-2024

| Patent document cited in search report | | | Publication date | Patent family member(s) | | | Publication date |
|---|---|---|---|---|---|---|---|
| US 2019063982 | A1 | | 28-02-2019 | CN | 109425408 | A | 05-03-2019 |
| | | | | DE | 102017119502 | A1 | 28-02-2019 |
| | | | | EP | 3447456 | A1 | 27-02-2019 |
| | | | | US | 2019063982 | A1 | 28-02-2019 |
| US 2018094962 | A1 | | 05-04-2018 | CN | 107884035 | A | 06-04-2018 |
| | | | | CN | 206556721 | U | 13-10-2017 |
| | | | | EP | 3301413 | A1 | 04-04-2018 |
| | | | | US | 2018094962 | A1 | 05-04-2018 |
| US 2020072652 | A1 | | 05-03-2020 | CN | 110873598 | A | 10-03-2020 |
| | | | | JP | 6472566 | B1 | 20-02-2019 |
| | | | | JP | 2020038110 | A | 12-03-2020 |
| | | | | KR | 20200027409 | A | 12-03-2020 |
| | | | | US | 2020072652 | A1 | 05-03-2020 |
| US 2018094963 | A1 | | 05-04-2018 | CN | 107884033 | A | 06-04-2018 |
| | | | | CN | 206321306 | U | 11-07-2017 |
| | | | | EP | 3301412 | A1 | 04-04-2018 |
| | | | | US | 2018094963 | A1 | 05-04-2018 |
| US 2022260470 | A1 | | 18-08-2022 | NONE | | | |
| US 2007194799 | A1 | | 23-08-2007 | CN | 101033996 | A | 12-09-2007 |
| | | | | EP | 1804038 | A1 | 04-07-2007 |
| | | | | US | 2007194799 | A1 | 23-08-2007 |
| US 2009302867 | A1 | | 10-12-2009 | CA | 2649466 | A1 | 01-11-2007 |
| | | | | DE | 102006019191 | A1 | 25-10-2007 |
| | | | | EP | 2010871 | A1 | 07-01-2009 |
| | | | | US | 2009302867 | A1 | 10-12-2009 |
| | | | | WO | 2007122116 | A1 | 01-11-2007 |
| US 2014104099 | A1 | | 17-04-2014 | NONE | | | |

EPO FORM P0459

For more details about this annex : see Official Journal of the European Patent Office, No. 12/82